# EUROPEAN PATENT SPECIFICATION

(11) **EP 0 402 128 B1**
(45) Date of publication and mention of the grant of the patent: **26.04.1995**
(21) Application number: 90306181.0
(22) Date of filing: 07.06.1990
(51) Int. Cl.: H01L 39/22, H01L 39/24

(54) **Method of forming an oxide superconductor/semiconductor junction**
Methode zur Herstellung eines oxydischen Supraleiter/Halbleiter-Überganges
Méthode de fabrication de jonction d'oxyde supraconductrice/semi-conductrice

(30) Priority: 09.06.1989 JP 145066/89
(43) Date of publication of application: 12.12.1990
(73) Proprietor: Oki Electric Industry Co., Ltd., Tokyo (JP)
(72) Inventor: Abe, Hitoshi, c/o Oki Electric Industry Co., Ltd., Tokyo (JP); Yamada, Tomoyuki, c/o Oki Electric Ind. Co., Ltd., Tokyo (JP)
(74) Representative: Boydell, John Christopher

(56) References cited:
- EP-A- 0 314 484
- APPLIED PHYSICS LETTERS, vol. 56, no. 5, 29th January 1990, pp. 490-492, New York, US; M.R. RAO et al.: "Molecular beam epitaxial growth of InAs on a TlBaCaCuO superconducting film"

## Description

### BACKGROUND OF THE INVENTION

This invention concerns a method of forming an oxide superconductor/semiconductor junction, and in particular, a method of forming an oxide superconductor/semiconductor junction wherein one of the constituent elements of the oxide superconductor is bismuth (referred to hereafter as Bi) or thallium (referred to hereafter as Tl), and the semiconductor is an elemental semiconductor or a Group III-V or Group II-VI compound semiconductor.

Conventionally, thin films of high temperature oxide superconductors such as Y₁Ba₂Cu₃Oₓ, Bi₂(Sr, Ca)₃Cu₂O_{y}, or Tl₂(Ba, Ca)₃CU₂O_{z} were formed on a substrate such as silicon (Si) by first forming a buffer layer of a substance such as MgO, ZrO₂, or BaTiO₃ (or SrTiO₃)/MgAl₂O₄ on a Si substrate, and then growing a thin film of the oxide superconductor on the buffer layer.

Methods where MgO or ZrO₂ are used as the buffer layer are disclosed, for example, in the following references:
Reference 1: Japanese Journal of Applied Physics, 27 [8] (August 1988). p. L1524-1526.
Reference 2: Appl. Phys. Lett.: American Institute of Physics, 52 [24] (13 June 1988), p.2068-2070.

A method where BaTiO₃ (or SrTiO₃)/MgAl₂O₄ is used as said buffer layer is disclosed in the following reference: Reference 3: Appl. Phys. Lett.: American Institute of Physics, 53 [20] (14 November 1988), p.1967-1969.

In addition to these methods where a junction between a high temperature oxide superconductor and a semiconductor is made using a suitable buffer layer, the oxide superconductor may be deposited directly on the Si or other substrate as disclosed in Reference 4.
Reference 4: Japanese Journal of Applied Physics, 27 [12] (December 1988), p.L2442-2444.

The technique described in this reference is known as laser ablation vapor deposition. It consists of heating and evaporating the bulk oxide superconductor by for example an eximer laser in order to deposit it on the Si or other substrate.

The conventional methods of forming an oxide superconductor/semiconductor junction by means of a buffer layer as described in references 1, 2 and 3, were effective in devices where the thin film of oxide superconductor was used as a superconductor, but they could not be applied in techniques where the interface with the elemental or compound semiconductor was used, as for example in complex superconductor/semiconductor devices such as the superconductor-base transistor disclosed in Japanese Patent Application No. 63-132850 proposed by the applicant of this application. Further, in the laser ablation vapor deposition method described in Reference 4, a bulk material of oxide superconductor is heated and vaporised by the laser. It is thus impossible to impose any conditions on the arrangement of atoms at the interface, and this method cannot therefore be applied to devices, such as for example the above-mentioned complex superconductor/semiconductor devices, which make use of the superconductor/semiconductor interface.

In summary, according to the prior art, when a thin superconducting film was formed by conventional techniques, Si reacted with the elements of the superconductor composition at the interface so that the properties of the film deteriorated, and due to reactions at the interface, the boundary became indistinct. In particular, an element such as Si which is easily oxidized reacted with the oxygen in the high-temperature oxide superconductor when and after the thin film is formed. In other words, as thin films of conventional superconductors were formed by methods such as sputtering, it was impossible to form a junction on a substrate of an elemental semiconductor or a semiconductor of a Group III-V or Group II-VI compound with a satisfactory interface. It was thus not possible to form junctions in superconductor transistors or the like.

### SUMMARY OF THE INVENTION

This invention was conceived to overcome the above disadvantages. It aims to provide a method of forming an oxide superconductor/semiconductor junction wherein, during or after the formation of a thin film of high-temperature oxide superconductor containing Bi or Tℓ upon a substrate of an elemental semiconductor or a Group III-V or Group II-VI compound semiconductors, reactions do not occur at the junction interface and the order of magnitude of the number of atoms in the interface can be strictly controlled. This makes it possible to form, for example, a superconductor-base transistor.

According to the present invention there is provided a method of forming an oxide superconductor/ semiconductor junction between an oxide superconductor containing bismuth or thallium and a semiconductor being an elemental semiconductor or a Group III-V or Group II-VI compound semiconductor, comprising the steps of: forming an atomic layer of silver of no more than 3 atoms thickness by vapor deposition of silver on the surface of said semiconductor; forming an atomic layer of bismuth or thallium of no more than 3 atoms thickness by vapor deposition of bismuth or thallium on said silver layer; heating the double atomic layer consisting of said silver and bismuth or of said silver and thallium to form a layer wherein the atoms of said silver and bismuth or silver and thallium are arranged regularly on the surface of said semiconductor; and forming said oxide superconductor to a specified thickness on said regularly arranged layer.

In this invention, layers comprising no more than 3 atom thicknesses of Ag and no more than 3 atom thicknesses of Bi or Tℓ, which is one of the principal components of an oxide superconductor, are formed on a semiconductor surface in the order Ag followed by Bi or Tℓ, and is then subjected to heat treatment. After the heat-treatment, a thin film of the oxide superconductor is grown. It is thus possible to strictly control the interface between superconductor and semiconductor at the atomic level. Atomic layers containing a regular arrangement of AgBi or AgTℓ are obtained at this interface, and a junction is formed with the layers having regularly arranged atoms. Experiments on the I - V characteristics of the semiconductor and thin film of oxide superconductor also confirm the formation of a Schottky junction. If semiconductors with a high impurity concentration are used, therefore, an ohmic junction with low contact resistance can be formed.

### BRIEF DESCRIPTION OF THE DRAWINGS

Figure 1 is a schematic illustration of a junction-forming apparatus required to form an oxide superconductor/semiconductor junction in one embodiment of this invention.

Fig. 2A to Fig. 2C are schematic sectional views showing the vapor deposition process of Ag and Bi on a Si substrate, and the regular arrangement that is obtained after heat treatment.

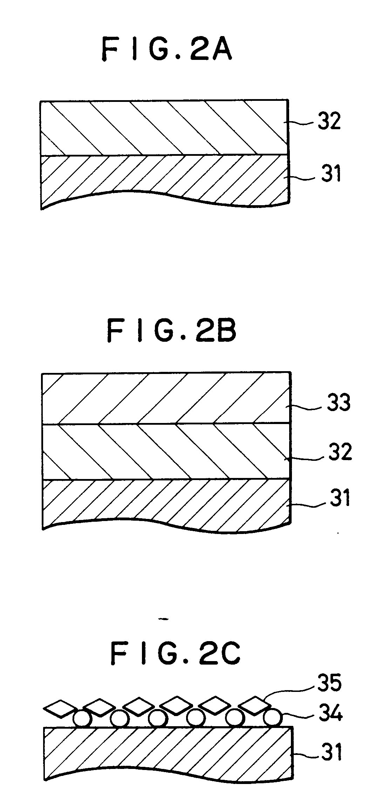

Fig. 2A is a schematic view of vapor-deposited Ag formed on a Si substrate.

Fig. 2B is a schematic view of vapor-deposited Bi formed on vapor-deposited Ag.

Fig. 2C is a schematic view of the regular arrangement of Ag atoms and Bi atoms obtained after heat treatment of the structure of Fig. 2B.

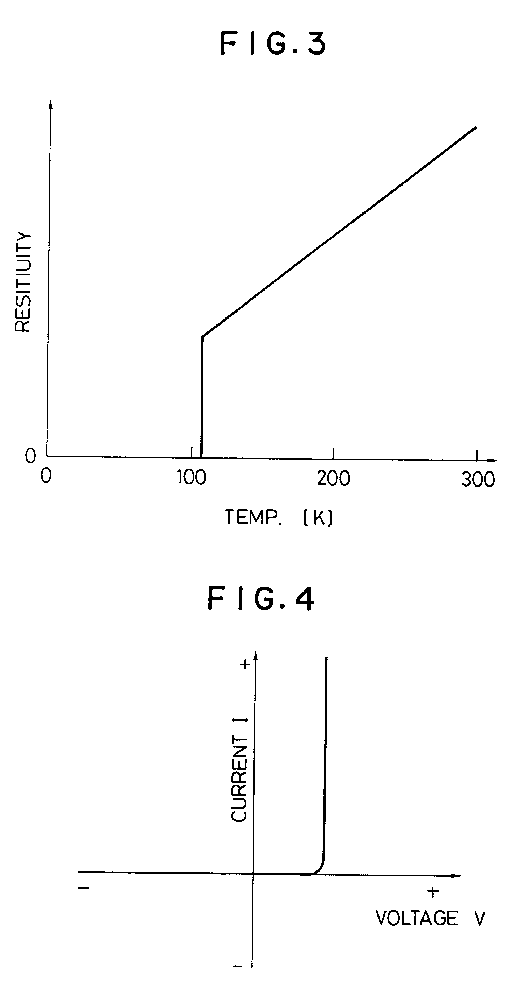

Fig. 3 is a characteristic graph showing the resistivity - temperature dependence of the Bi type oxide superconducting film obtained in this embodiment.

Fig. 4 is a graph showing the I - V characteristics of the Si substrate and superconducting film obtained in this embodiment.

### DETAILED DESCRIPTION OF TIlE PREFERRED EMBODIMENTS

Embodiments of this invention will now be described with reference to the drawings.

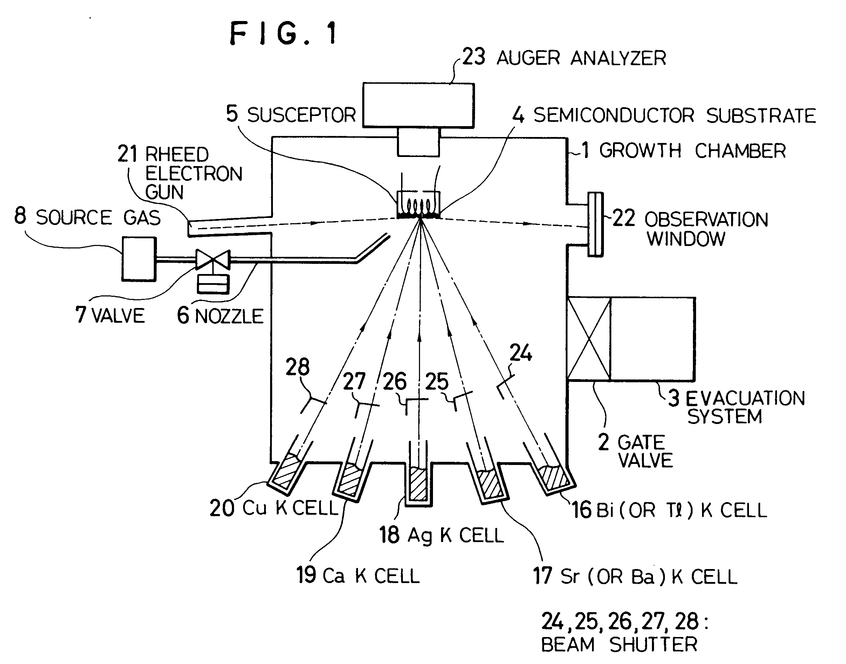

Fig. 1 is a schematic drawing of a junction forming apparatus to form an oxide superconductor/semiconductor junction in one embodiment of this invention. In the figure, 1 is a growth chamber, 2 is a gate valve for evacuation of chamber 1, and 3 is an evacuation system for evacuating chamber 1 when gate valve 2 is opened. 4 is a semiconductor substrate on which a junction is to be formed, and 5 is a susceptor containing a heating means (e.g. a heater). 6 is a nozzle installed from the outside of growth chamber 1 which projects into the interior of the chamber 1 near semiconductor substrate 4, 7 is a valve installed on nozzle 6, and 8 denotes source gases containing component elements of the oxide superconductor to be grown on semiconductor substrate 4. When the film is grown, source gases 8 are blown into chamber 1 from nozzle 6 through valve 7, and the pressure of source gases 8 is increased locally in the vicinity of the surface of semiconductor substrate 4. Source gases 8 may be introduced independently into chamber 1 from a number of different gas cylinders as required which are not shown in the drawing.

16 - 20 are Knudsen Cells (abbreviated hereafter as K cells) which evaporate metal elements to be used as components of the junction or oxide superconductor, and deposit them on semiconductor substrate 4, but the heating system is not shown for the sake of simplicity. If a Bi type oxide superconductor/semiconductor junction is to be formed, 16 is a Bi K cell, 17 is a Sr K cell, 18 is a Ag K cell, 19 is a Ca K cell, and 20 is a Cu K cell. In the case of a Tl type oxide superconductor, on the other hand, 16 is a Tl K cell, and 17 is a Ba K cell. Further, if other elements such as Pb are to be added, the number of K cells may be increased according to the desired objective. Further, 24 - 28 are beam shutters for K cells 16 - 20, respectively. During the growth of the oxide superconductor film, O₂, N₂O, O₃ or activated O₂ are supplied from nozzle 6. 21 is a RHEED (Reflection High-Energy Electron Diffraction) electron gun to investigate the crystalline nature of the film formed on the surface of semiconductor substrate 4, and 22 is a diffraction pattern observation window. Further, 23 is an Auger analyzer which uses high speed electrons as a probe in order to quantitatively measure the amount of vapor-deposition for the formation of the film of the the order of atoms deposited for making a junction on the semiconductor substrate.

The procedure of formation of an oxide superconductor/semiconductor junction will now be described taking as an example the case of a combination of a Si substrate with a Bi-Sr-Ca-Cu-O type superconductor. Firstly, a Si substrate 4 which has been thoroughly cleaned and subjected to surface etching is installed on susceptor 5, and the chamber is evacuated to a very high vacuum of about 1.33 x 10⁻⁹ Pa (10⁻¹¹ Torr) by evacuation system 3. Si substrate 4 is then heated to 1100° C or more by the heating system of susceptor 5 to remove oxides from its surface, and after cooling to room temperature, the Auger analyzer 23 and RHEED 21 are used to verify that its surface is clean in terms of the order of magnitude of numbers of atoms. If the surface is thoroughly clean, the output of the Auger analyzer will show no peaks apart from that of Si, and the RHEED reflection diffraction pattern obtained through the observation window 22 will be a (2 x 1) structural pattern for a Si (100) substrate.

Next, beam shutter 26 is opened, after the Ag K cell 18 has been heated so that Ag atoms are vaporized and sprayed onto Si substrate 4, which has a clean surface prepared as described above, so as to deposit Ag in an amount no more than that corresponding to a layer of 3 atoms thickness (about 5 x 10¹⁵ atoms/cm²). Beam shutter 26 is then closed. It is desirable that the pressure in growth chamber 1 during the deposition is no greater than 1.33 x 10⁻⁸ Pa (10⁻¹⁰ Torr). The amount of-deposition is measured by Auger analyzer 23.

Beam shutter 24 is opened, after Bi K cell 16 has been heated, so that Bi is deposited in an amount no more than that corresponding to a layer of 3 atoms thickness (about 5 x 10¹⁵ atoms/cm²), on the layer of Ag having a thickness of no more than 3 atoms. Beam shutter 24 is then closed. In this process also, it is desirable that the pressure in growth chamber 1 is no greater than 1.33 x 10⁻⁸ Pa (10⁻¹⁰ Torr), and the amount of deposit is measured by Auger analyzer 23. After depositing a double layer of nore more than 6 atoms thickness comprising no more than 3 atoms thickness of Ag and Bi respectively, the temperature of Si substrate 4 is raised to 500 - 600° C, preferably 500 - 550° C, and is maintained at such a raized temperature for about 25 minutes, while observing the RHEED pattern through observation window 22. The pattern suddenly becomes clear, and the vapor-deposited Ag and Bi adsorbed on the surface of Si substrate 4 appear to rearrange as if they had crystallized.

Fig. 2 is a schematic sectional view of the process of vapor deposition of Ag and Bi atoms on the Si substrate and the regular arrangement that is obtained after heat treatment. The amounts of both Ag and Bi atoms are each equivalent to a layer of no more than 3 atoms thickness which corresponds to a deposit of no more than about 5 x 10¹⁵ atoms/cm². In Fig. 2, Si substrate 4 of which the surface has been cleaned in the initial cleaning process (see Fig. 1) is indicated as Si substrate 31. Fig. 2A is a schematic view of the case where a deposit of Ag 32 is formed on Si substrate 31 to a thickness of no more than 3 atoms. Fig. 2B is a schematic view of the case where a deposit of Bi 33 is formed on the Ag deposit 32 in Fig. 2A to a thickness of no more than 3 atoms. Fig. 2C shows the regular arrangement of Ag atoms 34 and Bi atoms 35 on Si substrate 31 that is obtained by heating to 500 - 550° C as described in this embodiment.

When the RHEED diffraction patterns were observed through observation window 22, the Ag and Ag/Bi atomic layers shown in Figs. 2A and 2B were found to be polycrystalline (giving a weak diffraction pattern) or amorphous (giving no diffraction pattern). In comparison, the material subjected to heat treatment to produce the state shown in Fig. 2C gave a strong RHEED diffraction pattern. This confirmed that the surface of Si substrate 31 was completely covered with a regular arrangement of Ag atoms 34 and Bi atoms 35.

The method of forming an oxide superconductor layer will next be described. A Bi type oxide superconductor is formed to a desired thickness on Si substrate 31 in the state shown in Fig. 2C. The procedure for this formation will be explained.

Firstly, the temperature of Si substrate 31 is set to 500 - 550° C, the Bi, Sr, Ca and Cu K cells 16, 17, 19 and 20 are heated to the specified temperature, 0₃ gas is blown onto Si substrate 31 (semiconductor substrate 4 in Fig. 1) from nozzle 6, the beam shutters 24, 25, 27 and 28 are opened, and atomic beams of the respective elements are vapor-deposited on Si substrate 31 simultaneously to grow a Bi type oxide superconductor not shown in the figure. When the oxide layer has reached the desired thickness, the beam shutters are closed, and the heating of Si substrate 31 is stopped. The supply of 0₃ gas from nozzle 6 is continued until the substrate temperature falls below 200° C. When it has reached room temperature, the supply of 0₃ gas is stopped and the Si substrate 31 is removed from growth chamber 1. A thin film of a Bi type oxide superconductor is thereby formed on Si substrate 31 with the AgBi (or AgTl) layer, and the formation of the oxide superconductor/semiconductor junction of this invention is complete.

The formation of a junction between a Tl type oxide superconductor and semiconductor is achieved, as shown in the description of the apparatus of Fig. 1, by substituting the Bi of K cell 16 with Tl, and substituting the Sr of K cell 17 with Ba.

In the above embodiment, the case where a Si substrate is used for semiconductor substrate 4 was described. There is however no reason why other semiconductors cannot be used, i.e. elemental semiconductors such as Ge, or Group III-V compound semiconductors and Group II-VI compound semiconductors, and in these cases an oxide superconductor/semiconductor junction is formed which is similar to that in the above embodiment.

As explained in this embodiment, the oxide superconductor/semiconductor junction is formed by vapor deposition in which the order of magnitude of the numbers of atoms is controlled. It will therefore be understood that an essential condition for the success of the technique is that the pressure in chamber 1 where the junction is grown must be a very high vacuum such that the rate of deposition of the metal atoms used is sufficiently higher than the rate of adsorption of residual gas in the vacuum system.

The superconducting properties of the oxide superconductor, and the contact properties of the oxide superconductor/semiconductor junction, obtained by the junction-forming technique of this invention will next be described.

Fig. 3 is a graph of the temperature dependence of the resistivity of a Bi-Sr-Ca-Cu-0 type superconducting thin film with an oxide superconductor/semiconductor junction formed as in the above embodiment. The horizontal axis shows temperature [K], and the vertical axis is resistivity in arbitrary units (ρ = Ω .cm). As can be seen from Fig. 3, the temperature at which the resistivity changes abruptly and the critical temperature at which the resistivity is zero practically coincide with one another. This shows that a thin film of an excellent oxide high-temperature superconductor was obtained.

Fig. 4 is a graph showing the I-V characteristics of a a thin film of Bi type oxide high-temperature superconductor on a Si substrate formed as in the above embodiment of this invention. In the figure, the horizontal axis is voltage and the vertical axis is current, both in arbitrary units. As can be seen from the figure, the current increases rapidly, and this indicates extremely good Schottky characteristics. If an oxide superconductor/semiconductor junction is formed as in this invention using a Si substrate with a high concentration of impurities, good ohmic properties are obtained, and it will therefore prove extremely useful in application devices (in which the superconductor is employed) such as superconductor-base transistors.

According to this invention, in the formation of a Bi or Tl type oxide superconductor/semiconductor junction, a film of an oxide superconductor is grown on a semiconductor surface via a very thin film comprising a layer of AgBi or AgTl controlled at the atomic level. An oxide superconductor/semiconductor junction with excellent properties is thereby formed. Junctions formed by conventional techniques were always associated with problems such as large current leak and deterioration of interface properties, and this made them very difficult to incorporate in complex semiconductor/superconductor devices, but the application of this junction-forming technique vastly improves their characteristics.

## Claims

1. A method of forming an oxide superconductor/ semiconductor junction between an oxide superconductor containing bismuth or thallium and a semiconductor being an elemental semiconductor or a Group III-V or a Group II-VI compound semiconductor, comprising the steps of:
forming an atomic layer of silver of no more than 3 atoms thickness by vapor deposition of silver on the surface of said semiconductor;
forming an atomic layer of bismuth or thallium of no more than 3 atoms thickness by vapor deposition of bismuth or thallium on said silver layer;
heating the double atomic layer consisting of said silver and bismuth or of said silver and thallium to form a layer wherein the atoms of said silver and bismuth or silver and thallium are arranged regularly on the surface of said semiconductor; and
forming said oxide superconductor to a specified thickness on said regularly arranged layer.

2. A method according to claim 1, wherein said semiconductor is silicon.

3. A method according to claim 1, wherein the deposition of silver is made at a pressure not greater than 1.33 x 10⁻⁸ Pa (10⁻¹⁰ Torr).

4. A method according to claim 1, wherein the deposition of bismuth or thallium is made at a pressure not greater than 1.33 x 10⁻⁸ Pa (10⁻¹⁰ Torr).

5. A method according to claim 1, wherein the temperature of said heating is about 500 to 550°C.

6. A method according to claim 5, wherein during said heating the temperature is maintained at 500 to 550°C for about 25 minutes.

7. A method according to claim 1, wherein said oxide superconductor is bismuth type or thallium type.

## Patentansprüche

1. Verfahren zur Bildung eines Oxidsupraleiter/Halbleiter-Übergangs zwischen einem Oxidsupraleiter, der Wismut oder Thallium enthält, und einem Halbleiter, der ein Elementarhalbleiter oder ein Gruppe-III-V- oder Gruppe-II-VI-Verbindungshalbleiter ist, mit den Verfahrensschritten:
Bilden einer atomaren Silberschicht von nicht mehr als 3 Atomen Dicke durch Aufdampfen von Silber auf die Oberfläche des Halbleiters;
Bilden einer atomaren Wismut- oder Thalliumschicht von nicht mehr als 3 Atomen Dicke durch Aufdampfen von Wismut oder Thallium auf die Silberschicht;
Heizen der aus dem Silber und Wismut oder dem Silber und Thallium bestehenden doppelten atomaren Schicht, um eine Schicht zu bilden, in der die Atome des Silbers und Wismuts oder Silbers und Thalliums regelmäßig auf der Oberfläche des Halbleiters angeordnet sind; und
Bilden des Oxidsupraleiters mit einer spezifizierten Dicke auf der regelmäßig angeordneten Schicht.

2. Verfahren gemäß Anspruch 1, wobei der Halbleiter Silizium ist.

3. Verfahren gemäß Anspruch 1, wobei die Ablagerung von Silber bei einem Druck von nicht mehr als 1,33 x 10⁻⁸ Pa (10⁻¹⁰ Torr) durchgeführt wird.

4. Verfahren gemäß Anspruch 1, wobei die Ablagerung von Wismut oder Thallium bei einem Druck von nicht mehr als 1,33 x 10⁻⁸ Pa (10⁻¹⁰ Torr) durchgeführt wird.

5. Verfahren gemäß Anspruch 1, wobei die Heiztemperatur etwa 500 bis 550° C ist.

6. Verfahren gemäß Anspruch 5, wobei die Temperatur während des Heizens für etwa 25 Minuten auf 500 bis 550° C gehalten wird.

7. Verfahren gemäß Anspruch 1, wobei der Oxidsupraleiter ein Wismut- oder Thallium-Oxidsupraleiter ist.

## Revendications

1. Procédé de formation d'une jonction d'oxyde supraconductrice/semi-conductrice entre un supraconducteur oxyde contenant du bismuth ou du thallium et un semi-conducteur qui est un semi-conducteur élémentaire ou un semi-conducteur composé du Groupe III-V ou un semi-conducteur composé du Groupe II-VI, comprenant les étapes de :
formation d'une couche atomique d'argent d'au plus 3 atomes d'épaisseur par dépôt en phase vapeur d'argent sur la surface dudit semi-conducteur ;
formation d'une couche atomique de bismuth ou de thallium d'au plus 3 atomes d'épaisseur par dépôt en phase vapeur de bismuth ou de thallium sur ladite couche d'argent ;
chauffage de la double couche atomique consistant en lesdits argent et bismuth ou en lesdits argent et thallium pour former une couche dans laquelle les atomes desdits argent et bismuth ou desdits argent et thallium sont agencés de façon régulière sur la surface dudit semi-conducteur ; et
formation dudit supraconducteur oxyde à une épaisseur spécifiée sur ladite couche agencée de façon régulière.

2. Procédé selon la revendication 1, dans lequel ledit semi-conducteur est du silicium.

3. Procédé selon la revendication 1, dans lequel le dépôt d'argent est fait à une pression non supérieure à 1,33 x 10⁻⁸ Pa (10⁻¹⁰ Torr).

4. Procédé selon la revendication 1, dans lequel le dépôt de bismuth ou de thallium est fait à une pression non supérieure à 1,33 x 10⁻⁸ Pa (10⁻¹⁰ Torr).

5. Procédé selon la revendication 1, dans lequel la température dudit chauffage est d'environ 500 à 550° C.

6. Procédé selon la revendication 5, dans lequel, pendant ledit chauffage, la température est maintenue à une valeur de 500 à 550° C pendant environ 25 minutes.

7. Procédé selon la revendication 1, dans lequel ledit supraconducteur oxyde est du type bismuth ou du type thallium.
